# DEMANDE DE BREVET EUROPEEN

(11) **EP 1 343 208 A1**
(43) Date de publication de la demande: **10.09.2003**
(21) Numéro de dépôt: 03290467.4
(22) Date de dépôt: 27.02.2003
(51) Int. Cl.: H01L 29/788, H01L 27/115

(54) **Mémoire non volatile programmable et effaçable électriquement à une seule couche de matériau de grille**

(30) Priorité: 06.03.2002 FR 0202853
(71) Demandeur: STMicroelectronics S.A., 92120 Montrouge (FR)
(72) Inventeur: Dray, Cyrille, 38320 Eybens (FR); Gendrier, Philippe, 38000 Grenoble (FR); Fournel, Richard, 38660 Lumbin (FR)
(74) Mandataire: Casalonga, Axel

(57) **Abrégé**

Le dispositif semiconducteur de mémoire comprend une cellule-mémoire non volatile programmable et effaçable électriquement à une seule couche de matériau de grille et comportant au sein d'une zone active semiconductrice ménagée dans une région de substrat et délimitée par une région d'isolation, un transistor à grille flottante ainsi qu'une grille de commande. La couche de matériau de grille FG, PL, P2 dans laquelle est réalisée la grille flottante FG s'étend intégralement au-dessus de la zone active ZA sans chevaucher de partie de la région d'isolation STI, et le transistor est électriquement isolé de la grille de commande CG par des jonctions PN destinées à être polarisées en inverse.

## Description

L'invention concerne les circuits intégrés, et plus particulièrement les dispositifs semiconducteurs de mémoire du type non volatiles, programmables et effaçables électriquement à une seule couche de matériau de grille.

La structure d'un tel point mémoire est bien connue de l'homme du métier. Le brevet américain n° 5 761 121 en donne un exemple pour une structure PMOS.

Plus précisément, une telle cellule comporte un transistor à grille flottante et une grille de commande qui est réalisée par implantation au sein d'un substrat semiconducteur. Cette couche enterrée, qui fait office de grille de commande, est couplée de façon capacitive à la grille flottante. La grille de commande et le transistor à grille flottante sont électriquement isolés par une zone d'isolation, par exemple du type à tranchées peu profondes (STI : « Shallow Trench Isolation »).

La couche de matériau de grille, en général du polysilicium, au sein de laquelle est réalisée la grille flottante du transistor, est isolée de la zone active par un diélectrique, par exemple du dioxyde de silicium.

Il a été observé qu'il convenait de choisir une épaisseur du diélectrique supérieure à 60 Å, de façon à obtenir une bonne rétention des données. Or, il a été observé qu'il se produisait un amincissement du diélectrique de grille à l'interface entre la zone d'isolation, par exemple du type STI, et le matériau de grille. Il en résulte alors un problème de rétention de données.

L'invention vise à apporter une solution à ce problème.

L'invention a également pour but de fournir une telle mémoire dont le procédé de fabrication soit totalement compatible avec un procédé classique de fabrication CMOS.

L'invention propose donc un dispositif semiconducteur de mémoire, comprenant une cellule-mémoire non volatile programmable et effaçable électriquement à une seule couche de matériau de grille et comportant au sein d'une zone active semiconductrice ménagée dans une région de substrat et délimitée par une région d'isolation, un transistor à grille flottante ainsi qu'une grille de commande.

Selon une caractéristique générale de l'invention, la couche de matériau de grille dans laquelle est réalisée la grille flottante s'étend intégralement au-dessus de la zone active sans chevaucher de partie de la région d'isolation. Par ailleurs, le transistor est électriquement isolé de la grille de commande par des jonctions PN destinées à être polarisées en inverse.

En d'autres termes, la zone active est ici réalisée en une seule partie contrairement à l'art antérieur dans lequel elle était réalisée en deux parties séparées et isolées par des régions d'isolation. Le fait que la couche de matériau de grille s'étende intégralement au-dessus de la zone active sans chevaucher de partie de la région d'isolation, évite le problème de l'amincissement local du diélectrique de grille. Par ailleurs, l'isolation électrique entre la grille de commande et le transistor qui était obtenue dans l'art antérieur par une région d'isolation est obtenue ici par des jonctions PN polarisées en inverse.

Selon un mode de réalisation de l'invention, à l'intérieur de la zone active, le transistor à grille flottante, que l'on dénomme également ici « transistor de stockage », est électriquement isolé de la grille de commande par un transistor bipolaire destiné à être constamment bloqué et ayant une base dont le type de conductivité est différent du type de conductivité du canal du transistor.

A cet égard, la région de base du transistor bipolaire est par exemple une partie de la région de substrat.

Une solution pour éviter que la grille flottante du transistor de stockage ne déborde de la zone active et vienne par conséquent chevaucher une partie de la région d'isolation, consiste à prévoir une grille annulaire. Plus précisément, selon un mode de réalisation de l'invention, la zone active comporte une première région semiconductrice ayant un premier type de conductivité, et une deuxième région semiconductrice ayant un deuxième type de conductivité différent du premier. Le transistor est réalisé dans la première région semiconductrice et a une grille flottante annulaire constituée par une partie annulaire de la région de polysilicium de grille. La grille de commande est réalisée dans la deuxième région semiconductrice, et la région de matériau de grille comporte une deuxième partie située au dessus de la grille de commande ainsi qu'une partie de liaison reliant la partie annulaire et la deuxième partie.

Le fait de prévoir à l'intérieur de la zone active une isolation électrique entre le transistor de stockage et la grille de commande par des jonctions PN, crée un transistor MOS parasite dont la grille est formée par la partie de liaison de la couche de matériau de grille. Dans ce cas, afin de limiter la consommation de courant lors de l'effacement de la cellule-mémoire, on peut ajuster la dimension transversale de la partie de liaison à la finesse de gravure de la technologie.

Une autre solution consiste à réaliser une zone implantée spécifique située sous la partie de liaison, de façon à diminuer la tension de seuil du transistor parasite formé entre le transistor de stockage et la grille de commande.

Selon un mode de réalisation de l'invention, la région de substrat est formée d'un caisson principal semiconducteur ayant le premier type de conductivité (par exemple un caisson N) et incorporant la première région semiconductrice de la zone active. Le caisson principal contient un caisson secondaire ayant le deuxième type de conductivité (par exemple un caisson P) et incorporant la deuxième région semiconductrice de la zone active. A l'extérieur de la zone active le transistor de stockage est électriquement isolé de la grille de commande par des jonctions PN de caissons.

Le fait de prévoir une isolation électrique par des jonctions PN de caissons est particulièrement avantageux car de telles jonctions offrent une meilleure tenue en tension inverse.

Selon un mode de réalisation de l'invention, le dispositif comporte en outre des moyens de polarisation possédant un état de programmation de la cellule-mémoire, un état de lecture de la cellule-mémoire, et un état d'effacement de la cellule-mémoire.

Dans chacun des états, les moyens de polarisation sont aptes à appliquer des tensions prédéterminées sur la source, le drain et le substrat (caisson principal) du transistor de stockage et sur la grille de commande.

Par ailleurs, dans chaque état, la tension appliquée sur le substrat du transistor de stockage possède la valeur la plus élevée en valeur absolue si le substrat est de type N, ou la valeur la plus faible en valeur absolue si le substrat est de type P. Ceci garantit le blocage du transistor bipolaire d'isolation.

Par ailleurs, dans l'état de programmation, on appliquera de préférence une tension sur la grille de commande égale à la tension de substrat. On limite ainsi la contrainte électrique sur la jonction PN de caisson. Par ailleurs la quantité de charges injectées est plus importante.

Par ailleurs, dans l'état de lecture, on choisira avantageusement une différence de tension drain/source limitée à 1 volt en valeur absolue. Ceci permet d'éviter une reprogrammation très lente de la cellule-mémoire, ou bien une programmation parasite non-voulue d'une cellule-mémoire vierge.

Le transistor de stockage à grille flottante est de préférence un transistor PMOS. Ceci étant, l'invention s'applique également à un transistor de stockage du type NMOS.

Le dispositif peut comporter un plan-mémoire comportant plusieurs cellules-mémoires.

Le dispositif peut ainsi former une mémoire du type EEPROM ou du type FLASH.

L'invention a encore pour objet un circuit intégré comportant un dispositif tel que défini ci-avant.

D'autres avantages et caractéristiques de l'invention apparaîtront à l'examen de la description détaillée de modes de réalisation nullement limitatifs, et des dessins annexés, sur lesquels :
- les figures 1 à 3 illustrent schématiquement un mode de réalisation d'un dispositif de mémoire, selon l'invention ;
- les figures 1a à 3a représentent schématiquement des isolations électriques par jonctions PN, selon l'invention ; et
- la figure 4 illustre schématiquement des polarisations appliquées sur les électrodes d'un dispositif de mémoire selon l'invention, en fonction de l'état de ce dispositif.

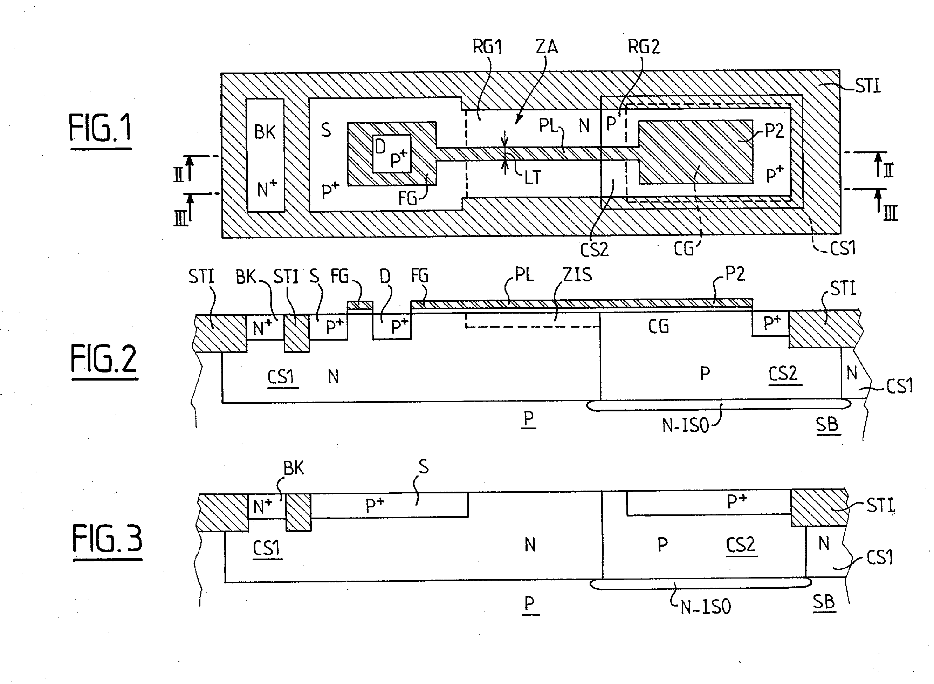

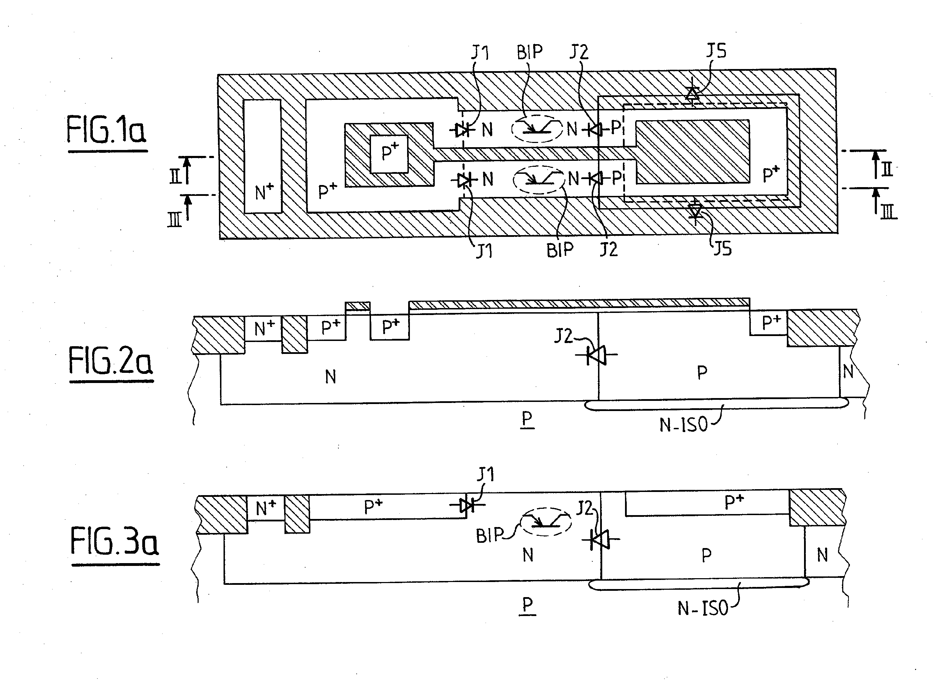

Sur les figures 2 et 3, qui sont respectivement des sections selon les lignes II-II et III-III de la figure 1, la référence SB désigne un substrat semiconducteur, par exemple en silicium dopé P⁻.

Dans ce substrat SB, est ménagée une zone active ZA en une seule partie, délimitée latéralement par une région d'isolation STI, ici par exemple une région d'isolation du type tranchées peu profondes.

Cette zone active ZA comporte une première région semiconductrice, ayant le type de conductivité N, et incorporée au sein d'un premier caisson semiconducteur, ou caisson principal, CS1 ménagé dans le substrat SB.

La zone active ZA comporte par ailleurs une deuxième région semiconductrice RG2, ayant le type de conductivité P, et incorporée au sein d'un deuxième caisson semiconducteur, ou caisson secondaire, CS2 ménagé dans le caisson principal CS1.

Le caisson CS2 est isolé du reste du substrat SB par une couche enterrée N-ISO, ayant le type de conductivité N.

Le caisson CS1 comporte par ailleurs une zone implantée de type N⁺, référencée BK, et permettant une prise de contact de façon à polariser le caisson CS1.

Au-dessus de la zone active, est prévue une couche d'un matériau de grille, par exemple du polysilicium, reposant sur la surface supérieure de la zone active ZA par l'intermédiaire d'un oxyde de grille, par exemple du dioxyde de silicium.

Cette unique couche de matériau de grille s'étend au-dessus de la zone active ZA, sans chevaucher à aucun endroit une quelconque partie de la zone d'isolation STI.

La couche de matériau de grille, qui forme dans son ensemble une grille flottante, comporte une première partie FG annulaire, disposée au-dessus du caisson CS1. Cette première partie de matériau de grille définit la grille FG d'un transistor dont la source S, formée d'une région implantée de type P⁺, se situe dans le caisson CS1 à l'extérieur de la grille flottante, et dont le drain D, formé également d'une région implantée de type P⁺, se situe dans le caisson CS1 à l'intérieur de l'anneau formant la grille FG.

Le transistor PMOS ainsi formé est également appelé ci-après le transistor de stockage de charges de la cellule-mémoire.

La couche de matériau de grille comporte également une deuxième partie P2, ici de forme rectangulaire, surplombant le caisson CS2.

La région du caisson CS2, située sous la deuxième partie P2 de la couche de matériau de grille, forme la grille de commande CG de la cellule-mémoire. Cette grille de commande est donc couplée de façon capacitive à la grille FG par l'intermédiaire de la deuxième partie P2 de la couche de matériau de grille et par l'intermédiaire d'une partie de liaison PL de cette couche de matériau de grille, reliant la grille FG et la deuxième partie P2.

De façon à permettre une prise de contact permettant une polarisation adéquate de la grille de commande CG, le caisson CS2 comporte une région implantée P⁺ située autour de la deuxième partie P2.

Il convient de noter ici que la forme de la deuxième partie P2 de la couche de matériau de grille peut être quelconque. Elle a été représentée ici rectangulaire et plus large que la partie de liaison PL. Elle pourrait être de même largeur que la partie de liaison PL, ou bien présenter une forme différente, par exemple une forme de H.

En fonctionnement, il convient que la grille de commande CG soit électriquement isolée du transistor de stockage à grille flottante.

Ceci est réalisé au moyen de jonctions PN destinées à être polarisées en inverse, et représentées schématiquement sur les figures 1a à 3a, qui sont analogues aux figures 1 à 3.

On voit sur ces figures qu'à l'intérieur de la zone active ZA, le transistor à grille flottante est isolé de la grille de commande par des premières jonctions PN J1 formées entre la région de source du transistor et le caisson CS1 de type de conductivité N, ainsi que par des jonctions PN J2 formées entre le caisson CS2 et le caisson CS1.

L'homme du métier aura alors noté que ces deux types de jonction J1 et J2 forment ensemble un transistor bipolaire BIP, dont on verra plus en détail ci-après qu'il est constamment bloqué ou inhibé quel que soit l'état de fonctionnement de la cellule-mémoire. L'isolation électrique entre le transistor à grille flottante et la grille de commande, est ainsi réalisée à l'intérieur de la zone active.

L'isolation latérale entre le transistor à grille flottante et la grille de commande CG, est réalisée également par des jonctions PN destinées à être polarisées en inverse. Plus précisément, ces jonctions comportent des jonctions de caisson J5 formées entre le caisson CS2 et le caisson CS1.

Le procédé de fabrication d'une telle cellule-mémoire comportant un transistor à grille flottante de type PMOS, et un transistor d'isolation bipolaire BIP du type PNP, comporte tout d'abord la réalisation connue en soi dans le substrat SB de type P⁻ des régions d'isolation latérale STI.

Puis, on procède de façon connue en soi à l'implantation des caissons CS1 et CS2, puis à la réalisation de la couche enterrée isolante N-ISO.

Puis, après avoir réalisé sur la surface de la zone active ZA une couche d'oxyde, on dépose une couche de matériau de grille que l'on grave de façon à former dans cette couche de matériau de grille la grille flottante du transistor, la partie de liaison PL et la deuxième partie P2. On procède ensuite à une désoxydation, puis à la réalisation des différentes régions implantées P⁺ ménagées dans les caissons CS1 et CS2. On procède également par implantation à la réalisation de la zone BK dopée N⁺.

On procède ensuite à une siliciuration classique des régions de source, de drain et de la prise de contact P⁺ de la grille de commande, en prenant toutefois dans cet exemple de réalisation la précaution, à l'aide d'un masque approprié, de ne pas siliciurer la grille flottante ni les jonctions en surface de la zone active ZA. On évite ainsi tout court-circuit métallique. En outre, le fait de pas siliciurer la grille flottante, permet une meilleure rétention des données.

On termine ensuite le procédé de fabrication par des prises de contact classiques sur les régions de source S, de drain D, sur la région BK et sur la grille de commande CG.

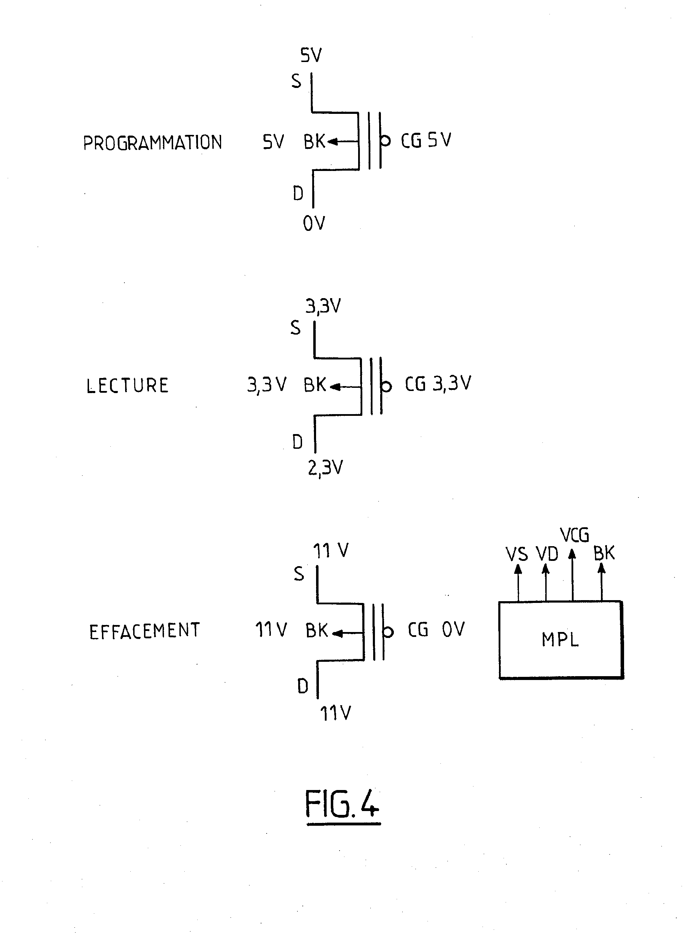

On va maintenant décrire, en se référant plus particulièrement à la figure 4, le fonctionnement de la cellule-mémoire selon l'invention.

A cet égard, le dispositif de mémoire selon l'invention, comporte des moyens de polarisation MPL, par exemple des sources de tension associées à une logique de commande, ces moyens de polarisation possédant un état de programmation de la cellule-mémoire, un état de lecture de cette cellule-mémoire et un état d'effacement de cette cellule-mémoire.

Dans chacun des états, les moyens de polarisation sont aptes à appliquer des tensions prédéterminées sur la source, le drain et le substrat du transistor de stockage (le substrat étant formé ici du caisson CS1), ainsi que sur la grille de commande.

Lorsqu'on veut programmer électriquement la cellule-mémoire, c'est-à-dire lorsqu'on veut stocker des charges dans la grille flottante, on applique par exemple sur la source du transistor de stockage une tension égale à 5 volts et sur le drain une tension égale à 0 volt. On polarise par ailleurs le substrat du transistor à 5 volts et on applique sur la grille de commande une tension qui peut varier par exemple entre 0 et 5 volts.

Le transistor de stockage est alors passant (sous réserve d'une tension grille/source suffisante pour initialiser la conduction du transistor de stockage), ce qui crée une saturation de ce transistor et provoque un courant de trous provenant de la source. Ces trous entrent en collision avec le réseau cristallin et forment des trous chauds et des électrons chauds. Les électrons chauds sont attirés dans la grille flottante dont le potentiel chute légèrement par rapport à celui appliqué sur la grille de commande.

Il convient de noter ici que plus la tension grille/source est faible, plus le potentiel de la grille flottante sera élevé par rapport au drain, et plus le champ électrique attirant les électrons chauds dans la grille flottante sera élevé.

Il est alors possible de réaliser un compromis entre l'intensité du courant et l'intensité du champ électrique. Ceci étant on choisira de préférence une tension VCG appliquée sur la grille de commande, égale à la tension VBK appliquée sur le substrat, de façon à limiter au maximum la contrainte électrique sur la diode de caisson J5, et à permettre en outre une injection plus importante de charges.

Par ailleurs, on remarquera que dans cet état, la tension VBK appliquée sur le substrat du transistor a en valeur absolue la tension la plus élevée. Or, comme la base du transistor bipolaire d'isolation BIP est une partie du substrat, le transistor BIP est dans son état bloqué.

Dans l'état de lecture, on limite volontairement la différence de tension drain/source à -1 volt de façon à éviter une reprogrammation très lente de la cellule-mémoire. On choisira ainsi par exemple une tension sur la source de 3,3 volts, et une tension sur le drain de 2,3 volts. Le substrat BK sera polarisé à 3,3 volts et la grille de commande CG pourra être polarisée avec une tension variant entre 0 et 3,3 volts.

Ainsi, si lors de la programmation, on a programmé un zéro dans la cellule-mémoire, c'est-à-dire si l'on n'a en fait effectué aucune programmation, le transistor sera bloqué lors de la lecture.

Si, par contre, lors de l'état de programmation, on a programmé un « 1 » (par exemple) dans la cellule-mémoire, c'est-à-dire si l'on a stocké des charges dans la grille flottante, le transistor conduira lors de la lecture. Ainsi, la détection ou non d'un courant dans l'état de lecture permet de déterminer la valeur logique qui a été écrite ou programmée dans la cellule. Là encore, dans cet état de lecture, la tension appliquée sur le substrat du transistor est la plus élevée, ce qui rend bloqué le transistor d'isolation bipolaire BIP, réalisant ainsi l'isolation électrique avec la grille de commande à l'intérieur de la zone active.

Pour procéder à l'effacement électrique de la cellule-mémoire, on applique par exemple des tensions de 11 volts sur la source, le drain et le substrat, et une tension de 0 volt sur la grille de commande, ce qui conduit à l'obtention d'une tension de 1 volt environ sur la grille flottante. Il s'ensuit une inversion du champ électrique et donc une évacuation des électrons.

Il convient de noter ici qu'il n'y a pratiquement pas de consommation de courant, car la tension sur la source est égale à la tension sur le drain.

Ceci étant, si l'on se réfère à nouveau plus particulièrement aux figures 1 et 2, on observe que la structure de cette cellule-mémoire conduit à la formation d'un transistor MOS parasite entre d'une part les régions de source et de drain dopées P⁺ du transistor à grille flottante et d'autre part le caisson CS2 dopé P. Le canal de ce transistor parasite est formé dans le caisson CS1 dopé N, sous la partie de liaison PL de la couche de matériau de grille.

Il s'ensuit donc un courant de fuite parasite lors de l'effacement de la cellule-mémoire, en raison de la conduction de ce transistor MOS parasite sous de fortes différences de tensions grille/source.

Afin de minimiser la consommation de courant, on peut alors adopter plusieurs solutions.

L'une d'entre elles consiste à minimiser la dimension transversale LT de la partie de liaison PL, c'est-à-dire la largeur du canal de ce transistor parasite. On choisira par conséquent une dimension transversale LT égale à la finesse de gravure utilisée dans la technologie employée. Ainsi, pour une technologie 0,18 µm, on choisira une largeur LT égale à 0,18 µm.

Une autre solution, qui n'est pas incompatible avec la première, consiste à modifier la tension de seuil de ce transistor parasite par une implantation spécifique ZIS, préalablement à la formation de la couche de matériau de grille. On cherche ainsi à modifier le dopage du caisson CS1 dans cette zone, de façon à modifier la tension de seuil du transistor MOS parasite et limiter la conduction de ce transistor parasite.

Il convient également de noter que le fait d'adopter dans l'état de programmation une tension VCGégale à la tension VBK, minimise le courant de conduction de ce transistor parasite dans l'état de programmation.

Bien que la cellule-mémoire non volatile programmable et effaçable électriquement qui vient d'être décrite utilise un transistor PMOS, une réalisation à base d'un transistor NMOS est également envisageable.

Par ailleurs, on peut prévoir plusieurs cellules-mémoires, de façon à former un plan-mémoire qui peut être effaçable bit par bit de façon à former une mémoire du type EEPROM, ou bien effaçable par banc ou par page de façon à former une mémoire du type FLASH.

## Revendications

1. Dispositif semiconducteur de mémoire, comprenant une cellule-mémoire non volatile programmable et effaçable électriquement à une seule couche de matériau de grille et comportant au sein d'une zone active semiconductrice ménagée dans une région de substrat et délimitée par une région d'isolation, un transistor à grille flottante ainsi qu'une grille de commande, **caractérisé par le fait que** la couche de matériau de grille (FG, PL, P2) dans laquelle est réalisée la grille flottante s'étend intégralement au dessus de la zone active (ZA) sans chevaucher de partie de la région d'isolation (STI), et **par le fait que** le transistor est électriquement isolé de la grille de commande (CG) par des jonctions PN destinées à être polarisées en inverse.

2. Dispositif selon la revendication 1, **caractérisé par le fait qu'**à l'intérieur de la zone active (ZA) le transistor de stockage est électriquement isolé de la grille de commande (CG) par un transistor bipolaire (BIP) destiné à être constamment bloqué et ayant une base dont le type de conductivité est différent du type de conductivité du canal du transistor.

3. Dispositif selon la revendication 2, **caractérisé par le fait que** la région de base du transistor bipolaire (BIP) est une partie de la région de substrat (CS1).

4. Dispositif selon l'une des revendications précédentes, **caractérisé par le fait que** la zone active (ZA) comporte une première région semiconductrice (RG1) ayant un premier type de conductivité, et une deuxième région semiconductrice (RG2) ayant un deuxième type de conductivité différent du premier, **par le fait que** le transistor à grille flottante est réalisé dans la première région semiconductrice (RG1) et a une grille annulaire (FG) constituée par une partie annulaire de la région de polysilicium de grille, **par le fait que** la grille de commande (CG) est réalisée dans la deuxième région semiconductrice (RG2), et **par le fait que** la région de matériau de grille comporte une deuxième partie (P2) située au dessus de la grille de commande (CG) ainsi qu'une partie de liaison (PL) reliant la partie annulaire (FG) et la deuxième partie (P2).

5. Dispositif selon la revendication 4, **caractérisé par le fait que** la source (S) et le drain (D) du transistor à grille flottante sont formés de deux zones ayant le deuxième type de conductivité (P⁺) et ménagées au sein de la première région semiconductrice, et **par le fait que** la dimension transversale (LT) de la partie de liaison (PL) est égale à la finesse de gravure de la technologie.

6. Dispositif selon la revendication 4 ou 5, **caractérisé par le fait que** la source (S) et le drain (D) du transistor à grille flottante sont formés de deux zones ayant le deuxième type de conductivité (P⁺) et ménagées au sein de la première région semiconductrice, et **par le fait que** la première région semiconductrice comporte une zone implantée spécifique (ZIS) située sous ladite partie de liaison (PL), de façon à modifier la tension de seuil du transistor parasite formé entre le transistor de stockage et la grille de commande.

7. Dispositif selon l'une des revendications 4 à 6, **caractérisé par le fait que** la région de substrat est formée d'un caisson principal semiconducteur (CS1) ayant le premier type de conductivité et incorporant la première région semiconductrice (RG1) de la zone active, **par le fait que** le caisson principal (CS1) contient un caisson secondaire (CS2) ayant le deuxième type de conductivité et incorporant la deuxième région semiconductrice (RG2) de la zone active, et **par le fait qu'**à l'extrérieur de la zone active le transistor de stockage est électriquement isolé de la grille de commande par des jonctions PN de caissons (J5).

8. Dispositif selon l'une des revendications précédentes, **caractérisé par le fait qu'**il comporte en outre des moyens de polarisation (MPL) possédant un état de programmation de la cellule-mémoire, un état de lecture de la cellule-mémoire, et un état d'effacement de la cellule-mémoire, **par le fait que** dans chacun des états, les moyens de polarisation sont aptes à appliquer des tensions prédéterminées sur la source, le drain et le substrat du transistor de stockage et sur la grille de commande, et **par le fait que** dans chaque état, la tension appliquée sur le substrat du transistor de stockage possède la valeur la plus élevée en valeur absolue si le substrat est de type N, ou la valeur la plus faible en valeur absolue si le substrat est de type P.

9. Dispositif selon la revendication 8, **caractérisé par le fait que** dans l'état de programmation, la tension (VCG) appliquée sur la grille de commande est égale à la tension de substrat (VBK).

10. Dispositif selon la revendication 8 ou 9, **caractérisé par le fait que** dans l'état de lecture, la différence de tension drain/source est limitée à 1 volt en valeur absolue.

11. Dispositif selon l'une des revendications précédentes, **caractérisé par le fait que** le transistor de stockage est un transistor PMOS.

12. Dispositif selon l'une des revendications précédentes, **caractérisé par le fait qu'**il comporte un plan-mémoire comportant plusieurs cellules-mémoires.

13. Dispositif selon l'une des revendications précédentes, **caractérisé par le fait qu'**il forme une mémoire du type EEPROM ou du type FLASH.

14. Circuit intégré, **caractérisé par le fait qu'**il comporte un dispositif selon l'une des revendications 1 à 13.
